# NEW EUROPEAN PATENT SPECIFICATION

(11) **EP 0 117 654 B2**
(45) Date of publication and mention of the opposition decision: **12.05.1993**
(45) Mention of the grant of the patent: 17.09.1986
(21) Application number: 84300592.7
(22) Date of filing: 31.01.1984
(51) Int. Cl.: H04B 1/64, H03G 7/00

(54) **Multistage amplifier**
Mehrstufiger Verstärker
Amplificateur multi étage

(30) Priority: 31.01.1983 JP 14407/83
(43) Date of publication of application: 05.09.1984
(73) Proprietor: FUJITSU LIMITED, Kawasaki-shi, Kanagawa 211 (JP)
(72) Inventor: Sasaki, Susumu c/o Fujitsu Limited, Nakahara-ku Kawasaki-shi Kanagawa, 211 (JP)
(74) Representative: Sunderland, James Harry

(56) References cited:
- EP-A- 0 023 948
- DE-A- 1 616 101
- DE-A- 2 629 957
- DE-A- 2 914 092
- DE-B- 2 260 072
- DE-B- 2 316 540
- DE-B- 2 535 695
- FR-B- 1 602 358
- US-A- 4 114 115
- Frequenz, Vol. 23, 1969, nr. 2, pages 34,37,38

## Description

This invention relates to a multistage amplifier, more particularly a high quality amplifier circuit for telecommunication equipment, providing linear inpu- toutput characteristics over a wide range of variation of input signal level.

When a multistage amplifier circuit is employed in a case in which its input signal level can vary over a wide range, its output level must be linearly related to input signal level up to the highest possible level of the input signal. Further, due to the nature of transmission or telecommunications equipment, the amplifier circuits is generally required to have low noise characteristics for the lowest level of the input signal. Low cost and small size are also required.

An example of a multistage amplifier circuit is a microwave receiver for a radio relay system.

Such a microwave receiver will generally have a first stage amplifier operating at ratio frequency, an interstage amplifier operating at intermediate frequency and a last stage amplifier also operating at intermediate frequency.

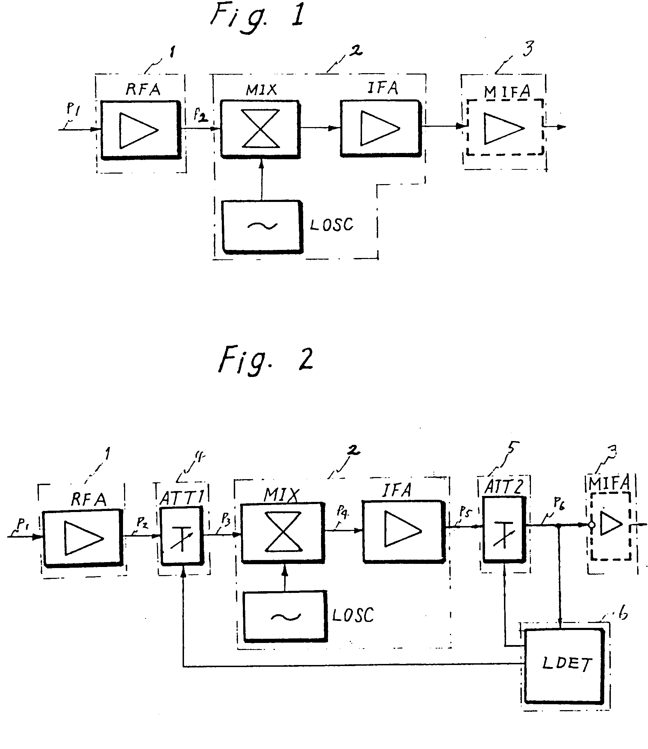

Fig. 1 of the accompanying drawings is a schematic block diagram of a multistage amplifier circuit. In Fig. 1, 1 is a first stage amplifier, 2 is an interstage circuit and 3 is a last stage amplifier. First stage amplifier 1 is a radio frequency amplifier RFA. Interstage circuit 2 comprises a frequency mixer MIX, a local oscillator LOSC, and an intermediate frequency preamplifier IFA. Last stage amplifier 3 is an intermediate frequency main amplifier MIFA.

A radio frequency signal P₁ from a receiving antenna (not shown) is applied to radio frequency amplifier RFA. The output signal P₂ of rf amplifier RFA is mixed with the output of local oscillator LOSC in the frequency mixer MIX. By the mixer, the radio frequency (fr) input signal to the interstage circuit is converted to a signal of intermediate frequency fit. Frequency fit is the difference frequency between input radio frequency fᵣ and local oscillator frequency floc, and frequency fit may be selected to be 70 MHz for example.

The input level P₁ (of radio frequency signal P₁) of the microwave receiver can vary from its standard level over a wide range, due to the phenomenon known as "fading". Fading is caused by changes of meteorological conditions along a propagation path of radio waves.

A microwave receiver, as a multistage amplifier, is required to have linear input-output characteristics up to the highest level of input signal which can arise as a result of the fading phenomenon, and is required to generate little noise even at the lowest level of input signal.

In the receiver circuit of Fig. 1, the first stage amplifier RFA of the multistage amplifier circuitry is required to be a low noise and high gain amplifier to provide a receiver which, overall, has low noise characteristics. Consequently, when the input signal applied to the first stage amplifier RFA reaches a high level, due to fading, the output signal of frequency mixer MIX and pre-amplifier IFAwill be saturated or distorted.

In order to avoid the saturation in the mixer or pre-amplifier circuit it has been necessary to employ expensive circuitry and components.

French Patent 1 602 358 discloses a multistage amplifier having features corresponding to those of the preamble of accompanying claim 1. An analogue processing circuit is provided for performing operations such as multiplication or division on slowly-varying DC or AC signals.

According to the present invention, there is provided a multistage amplifier, comprising:-
level compressor means for level-compressing a signal supplied thereto;
signal processing means, operatively connected to the level compressor means, for processing the level-compressed output signal provided by the level compressor means;
level expandor means, operatively connected to the signal processing means, for level-expanding the amplified level-compressed output signal provided by the signal processing means, operable so that an amount of level-expansion effected by the level expandor means corresponds to an amount of level compression effected by the level compressor means; and
level detecting means for detecting a level of a signal in the multistage amplifier, and operable in dependence thereupon to control the level compressor means and the level expandor means so that complementary amounts of level-compression and level-expansion are provided;
   characterised in that:-
first-stage amplifying means are provided for amplifying an input signal of said multistage amplifier and supplying an output signal, linearly related in level to the input signal, to said level compressor means; in that the amount of level-compression provided by the level compressor means and the amount of level-expansion provided by the level expandor means are each continuously variable and proportional to the amount by which the level of the signal detected by said level detecting means exceeds a preset signal level, said preset signal level being set in correspondence to a saturation signal level of the signal processing means; in that said signal processing means is an interstage amplifier means for linearly amplifying the level-compressed output signal of the level compressor means; and in that the signal a level of which the level detecting means are for detecting is a signal associated with the interstage amplifying means, for example the level-compressed output signal or the amplified level-compressed output signal;
whereby the output signal from the multistage amplifier is linearly related to the input signal thereof and free from distortion generated in said interstage amplifier means, and thus suitable for use in telecommunications.

An embodiment of the present invention can economically provide a multistage amplifier having a linear input-output characteristic over a wide range of input signal levels, with low noise characteristics.

Briefly, in an embodiment of the present invention, to ensure an overall low noise characteristic, a first stage of the multistage amplifier is designed to have a low noise figure and a high power gain. An interstage amplifier is designed to have a moderate noise figure and a moderate power gain, which are sufficient that deterioration of overall noise figure due to noise in the last stage amplifier is negligible.

Extension of the range of input signal levels over which a linear input-output characteristic can be achieved is provided in an embodiment of the present invention by inserting first and second variable attenuators at the input and output of the interstage circuit respectively. The first and second variable attenuators are controlled simultaneously by a level detector. The level detector controls the first and second attenuator such that the first variable attenuator begins to increase its attenuating factor, and the second variable attenuator begins to decrease its attenuation factor, when the level detector detects a preset level of signal, for example at the input or the output of the interstage circuit. Furthermore, attenuation characteristics of the first variable attenuator are complementary to those of the second variable attenuator.

For example, the level detector provides each of the first and second attenuators with a separate dc current to control its attenuation.
The first variable attenuator works as a level compressor for incoming signals from the first stage amplifier which are higher than a preset level. The second variable attenuator works as a level expandor for incoming signals from the interstage amplifier to compensate the signal level compression by the first variable attenuator.

By combined operation of first and second variable attenuators, it is possible to avoid saturation in the interstage circuit for input signals higher than a preset level and to extend the range overwhich linear input-output amplification characteristics are provided for a multistage amplifier circuit, while maintaining low noise performance.

Reference is made, by way of example, to the accompanying drawings, in which:
Fig. 1 is a schematic block diagram of a multistage amplifier of a frequency converter type;
Fig. 2 is a schematic block diagram of a multistage linear amplifier of a frequency converter type, embodying the present invention;
Fig. 3 is a schematic block diagram of another multistage linear amplifier of a frequency converter type, embodying the present invention;
Fig. 4 is a schematic circuit diagram of variable attenuators for use in the multistage linear amplifiers of Figures 2 and 3;
Fig. 5(a) is a graph illustrating series resistance vs dc forward bias current of a diode;
Fig. 5(b) is a graph illustrating diode forward current as supplied to an attenuator as shown in Fig. 4 vs input signal level as supplied to a multistage linear amplifier as shown in Fig. 2 or 3;
Fig. 5(c) is a graph of attenuation of an attenuator as shown in Fig. 4 vs input signal level as applied to a multistage linear amplifier as shown in Fig. 2 or 3;
Fig. 6 is a schematic block diagram of another multistage linear amplifier, of a cascaded amplifier type, embodying the present invention;
Fig. 7 is a schematic block diagram of another multistage linear amplifier, of a cascaded amplifier type, embodying the present invention;
Fig. 8 is a graph of input signal level vs outputsig- nal level fora multistage linear amplifier embodying the present invention; and
Fig. 9 is a schematic block diagram of a space diversity receiver system using multistage linear amplifiers embodying the present invention.

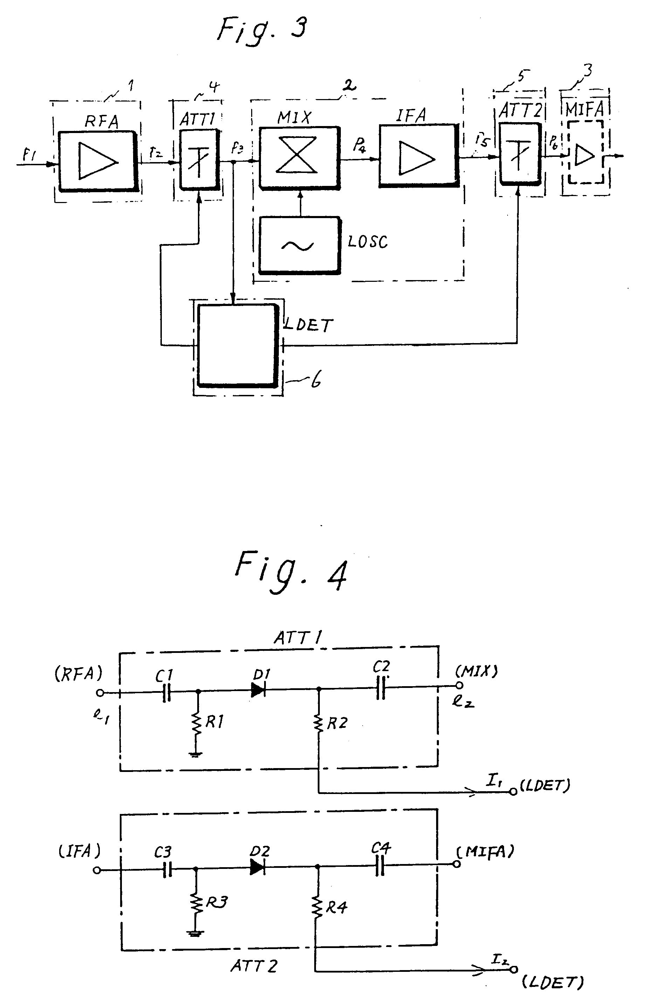

In Figures 2 and 3, which are block diagrams of multistage linear amplifiers of a frequency converter type embodying the present invention, the same reference signs as appear in Fig. 1 designate the same or similar circuitry or circuitry parts.

In each of Figures 2 and 3, 4 is a first variable attenuator ATT1, 5 is a second variable attenuator ATT2, and 6 is a level detector LDET.

First variable attenuator 4 is inserted between first stage amplifier 1 and interstage circuit 2. Second variable attenuator 5 is inserted between interstage circuit 2 and last stage amplifier 3.

Input signal level P₁ of the first stage amplifier 1 may vary over a wide range, from a lowest level P_{lL} to a highest level P_{1H}. The levels P_{lL} and P_{lH} are the lowest and highest levels of the input signal P₁ representing transmission quality design limits of the multistage linear amplifier circuit.

Level P₁ₚ is a standar level of input signal P, when fading of the input signal is negligibly small.

In Figures 2 and 3 P₂, P₃, P₄, P₅ and P₆ are output signal levels of radio frequency amplifier RFA, first attenuator ATT1, frequency mixer MIX, intermediate frequency pre-amplifier IFA, and second attenuator ATT2 respectively. P_{ilL} and P_{ilH,} where i is a number from 2 to 6, are the lowest and highest values of the sign levels P₂ to Pₛ, corresponding to the levels P_{lL} and Pin of input signal P₁.

In the following description, reference sign P will, for the sake of simplicity, be used with two meanings, one designating a signal level, the other designating a signal having the level P. For example, input signal P₁ means an input signal whose signal level is P₁.

In each of Figures 2 and 3, input signal P₁ is amplified by amplifier RFAto provide an output P₂, which varies from P_{2L} to P_{2H}, corresponding to variation in input level from P_{1L} to P_{1H.} The first stage amplifier RFA is designed to have a low noise figure, to meet the overall noise specification at a lowest signal level P_{1L.} Power gain of amplifier RFA is sufficient that de- terioriation of overall noise figure due to noise of subsequent stages can be neglected.

The output signal P₂ of the first stage amplifier is applied to the first variable attenuator ATT1. Attenuation of the attenuator ATT1 is controlled by the level detector LDET as follows.

Attenuation of ATT1 is controlled to be held to a minimum attenuation when the level P₂ is less than the level P₂p which corresponds to the standard level P_{1P.}

The level P₂p is determined in connection with a level P₃p, a limiting level for input signals to mixer circuit MIX to avoid saturation in the circuit.

When the level P₂ exceeds the level P₂p, attenuation of attenuator ATT1 is controlled to begin to increase beyond its minimum attenuation.

When the level P₂ is between P₂p and P_{2H}, that is, when input signal level P₁ is between P_{1P} and P_{1H,} attenuator ATT1 provides an attenuation equal to the amount or increment by which signal level P₂ is above P₂p.

Thus, the output level P₃ of first attenuatorATT1, corresponding to an input level in the range from P₂p to P_{2H}, is compressed and held to a constant level P_{3P.}

Therefore, the output level P₃ of the attenuator ATT1 varies only from P_{3L} to P₃p, corresponding to variation of the input signal P₁ from P_{1L} to P_{1H.} In the range of variation of P₃, levels from P_{3L} to P₃p correspond to P₁ input levels from P_{1L} to P₁ₚ, and levels from P₃p to P_{3H} are compressed to the level P_{3P.}

Signal level P₃ the output signal of ATT1, is applied to the mixer MIX, and is mixed with an output of local oscillator LOSC to produce an intermediate frequency signal P₄.

Conversion from a radio frequency signal to an intermediate frequency signal brings about a level loss, but saturation of the mixer is no problem because of the level compression byATT1, and linear conversion is maintained. Because signal level is low (the highest level of rf signal is limited to the specified level P₃p), P₃p is the maximum level for which linear conversion need be guaranteed.

Level P₄, the output level of the mixer MIX, varies linearly from level P_{4L} to level P₄p corresponding to variation of level P₃ from P_{3L} to P_{3P.} Output signal P₄ of converter MIX is applied to a pre-amplifier IFA. The pre-amplifier IFA provides output signal P₅. The output signal level P₅ varies from P_{5L} to P₅p, in correspondence to variation of P₄ from P_{4L} to P_{4p.}

The signal P₅ is applied to second variable attenuator ATT2. Attenuator ATT2 is controlled by the level detector LDET.

In Fig. 2, the level detector LDET provides a dc current in dependence upon the detected output level P₆ of the amplifying ATT2. The dc current is proportional of the dc voltage detected by he detector LDET. Until the dc voltage detected by the level detector LDET reaches a preset dc voltage, the attenuation of attenuator ATT2 is controlled to remain at a constant attenuation A₂ₘₐₓ. The preset dc voltage corresponds to a preset signal level of P₆p which corresponds to the P₃p input level of the mixer MIX.

Maximum attenuation A₂ₘₐₓ of the attenuator ATT2 is designed to correspond (be equal) to the difference between highest level P_{1H} and standard level P₁ₚ of input signal P₁ and A₂ₘₐₓ is equal to maximum attenuation A₁ₘₐₓ of attenuator ATT1.

If the dc voltage detected by the level detector LDET exceeds the dc voltage corresponding to the signal level P_{6p,} attenuatorATT2 is controlled to begin to reduce its attenuation from its maximum attenuation A_{2max.} Therefore, level Pₛ, the output level of attenuatorATT2, goes up. The attenuatorATT2 reduces its attenuation in proportion to increment of signal level from level P₆p (in proportion to the amount by which signal level exceeds P₆ₚ) for a signal level between P₆p and P_{6H.} At the highest level P_{6H,} the attenuation of ATT2 is a minimum attenuation A_{2min,} practically zero attenuation.

The first variable attenuatorATT1 and second variable attenuator ATT2 are simultaneously controlled by the level detector LDET. Therefore, the signal level provided by compression in first variable attenuator ATT1 is expanded to signal levels in the range from P₆p to P_{6H} by reducing the attenuation of the second variable attenuator ATT2.

In Fig. 3, the detector LDET detects the output level P₃ of attenuator ATT1 and in dependence thereupon controls the attenuation of ATT1 and ATT2. It will be clear, however, that the operation of the circuit of Fig. 3 is quite similar to that of Fig. 2. A linear relationship between input signal level P₁ of the first stage amplifier RFA and output level P₆ of attenuator ATT2 is attained by the combined operation of attenuator ATT1 and ATT2, similarly to Fig. 2.

Fig. 4 shows a schematic circuit diagram of a first variable attenuator ATT1 for a radio frequency signal and a second variable attenuator ATT2 for an intermediate frequency signal. The circuit configurations and principles of operation of the attenuators ATT1 and ATT2 are the same, but circuit components differ in accordance with the different frequencies handled.

An explanation of the first attenuator ATT1 will be given below.

First attenuator ATT1 consists of a capacitor C1 for input coupling, a forward biased diode D1, resistors R1 and R2 for a variable resistance circuit, and a capacitor C2 for output coupling.

Attenuation of attenuator ATT1, that is, the ratio of input level e₁ to output level e₂, can be determined by the ratio R2/(r1 + R2), where r1 is the resistance of diode D1. The attenuation can be controlled by changing the diode resistance r1 of diode D1. The diode resistance r1 is varied by changing a magnitude of forward current 11 supplied to diode D1.

When the forward current 11 is large, diode resistance r1 is small, and consequently attenuation is small. When forward current 11 is small, diode resistance r1 is large, and attenuation is large. The forward dc current 11 is supplied (controlled) by the level detector LDET.

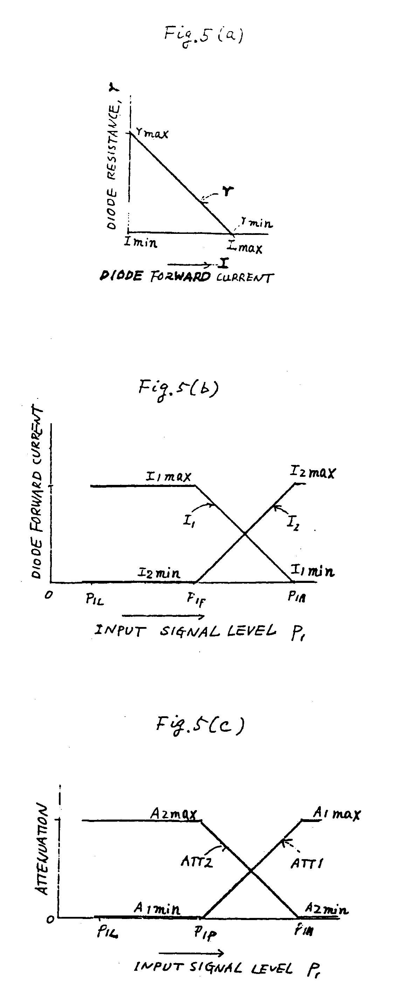

Fig. 5(a) is a graph illustrating diode resistance r vs diode forward current I. When forward current I is minimum Imin, diode resistance r is maximum rmax, and when forward current I is maximum Imax, diode resistance r becomes minimum rₘᵢₙ.

As forward diode current I is decreased, and resistance r is increased, the attenuation of the attenuator increases. As the forward current I is increased, and resistance r is decreased, the attenuation of the attenuator decreases. When diode resistance r is maximum rmax, the attenuation is a maximum Aₘₐₓ. When the resistance r is minimum r_{min,} the attenuation is a minimum Amin.

Fig. 5(b) is a graph illustrating relationships between input signal level P₁ of the multistage amplifier (X axis in the graph) and dc currents 11 and 12 supplied respectively to attenuators ATT1 and ATT2 (Y axis in the graph) (by LDET).

At a specified level P₁ₚ of input signal P₁, dc current 11 begins to decrease, dc current 12 begins to increase. The values of dc currents 11 and 12 bear an inverse relationship to one another, and currents 11 and 12 are respectively supplied to diode D1 of attenuator ATT1 and diode D2 of attenuator ATT2 as their forward bias currents.

The level P₁ₚ is a standard level for the input signal, which is a level above which some part or component circuit of the interstage circuit will begin to saturate.

In Fig. 5(c) is a graph illustrating the relationships between the attenuations provided by attenuators ATT1 and ATT2 and input signal P₁ level. When input signal P₁ is less than the standard level P₁p, attenuation of attenuatorATT1 is held to minimum attenuation A_{1min'} and attenuation of attenuator ATT2 is held to maximum attenuation A₂ₘₐₓ. When input signal P₁ is higher than the standard level P₁p, attenuation of amplifying ATT1 is increased, and attenuation of ATT2 is decreased. When input signal is at the highest level P_{1H'} attenuation of attenuator becomes maximum A₁ₘₐₓ, and attenuation of attenuator ATT2 becomes minimum A₂ₘᵢₙ. When input signal P₁ is between P₁p and P_{1H'} the amount or increment by which the attenuation of attenuator ATT1 is increased from A₁ₘᵢₙ is equal to the amount or decrement by which the attenuation of ATT2 is decreased from A₂ₘₐₓ.

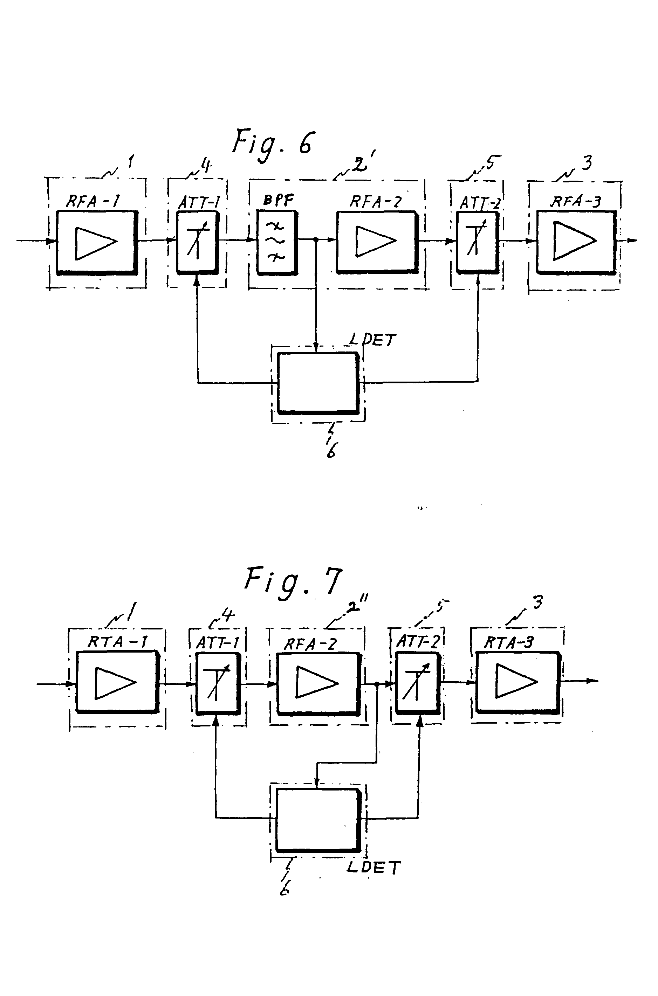

Further embodiments of the present invention, applied to cascaded amplifier type multistage circuits, are shown in Figures 6 and 7.

A cascaded amplifier as shown in the block diagram of Fig.6, has a first stage amplifier 1 which is an rf amplifier RFA-1, an interstage circuit 2' comprising a band pass filter BPF and rf amplifier RFA-2, and a last stage amplifier 3 which is an rf amplifier RFA-3, a first variable attenuator (ATT-1) 4, a second variable attenuator (ATT2) 5 and a level detector (LDET) 6.

In the amplifier of Fig.6, rf amplifier RFA-2 of the interstage circuit 2' is a circuit with low level saturation characteristics, because the amplifier RFA-2 must be a low noise amplifier in order to reduce the noise due to loss in band pass filter BPF which is inserted between rf amplifiers RFA-1 and RFA-2. Such a low noise amplifier is generally saturated by a low level signal. Band pass filter BPF is used to limit frequency bandwidth of the radio frequency signal. Insertion loss of the band pass filter BPF is sometimes large.

First variable attenuator 4, ATT1 is inserted between first stage signal 1, RFA-1 and the band pass filter BPF of interstage circuit 2'. Second variable attenuator 5, ATT2 is inserted between interstage circuit 2', RFA-2 and last stage amplifier 3, RFA-3. Level detector 6, LDET controls the attenuators ATT1 and ATT2 in dependence upon detection of the input level of amplifier RFA-2. The operations of attenuators ATT1 and ATT2 in this circuit are similar to the operations of ATT1 and ATT2 in the circuit of Fig. 2.

By the combined operation of attenuators ATT1 and ATT2, as in the circuit of Fig. 2, saturation of amplifier RFA-2 can be avoided and a linear relationship between inputsignal level offirst stage amplifier RFA-1 and output level of second attenuator ATT2 can be attained.

In the circuit of Fig. 7, an interstage circuit 2", RFA-2 is provided which is a low level saturation circuit, in order to reduce cost. First variable attenuator 4, ATT1 is inserted between first stage amplifier 1, RFA-1 and interstage circuit 2", RFA-2. Second variable attenuator 5, ATT2 is inserted between circuit 2", RFA-2 and last stage amplifier 3, RFA-3. Level detector 6, LDET controls the attenuators ATT1 and ATT2 by detecting the output level of interstage amplifier 2, RFA-2.

By the combined operation of attenuators ATT1 and ATT2, in a similar way to operations described with reference to Fig. 2, it is possible to achieve linear amplification operation of the cascaded amplifier for input signals higher than standard level.

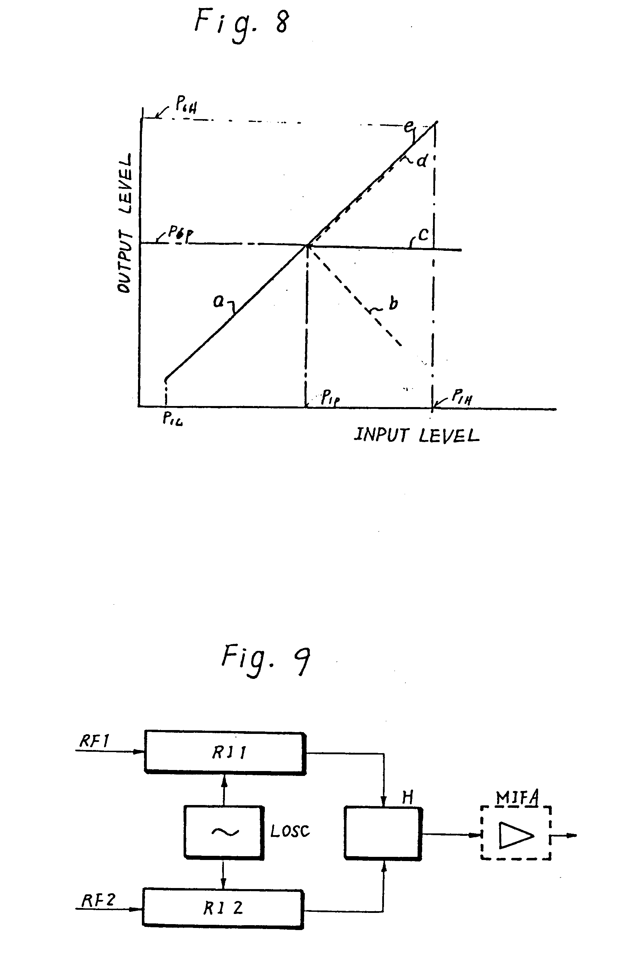

Fig. 9 is a block diagram of a space diversity reception system, using two multistage linear amplifier sets of a frequency converter type.

Radio frequency signals RF1 and RF2 are input signals from two attenuates (antennas), each installed separately at a different location or height. Input signal of RF1 and RF2 vary independently of each other over wide ranges.

Input signals of RF1 and RF2 are respectively applied to first stage amplifiers of multistage linear and low noise receivers RI1 and R12. The signals RF1 and RF2, of radio frequency, are frequency-converted separately by a common local oscillator LOSC to signals of intermediate frequency.

The intermediate frequency signals are amplified respectively by pre-amplifiers of receivers RI1 and R12. The output voltages of the respective pre-amplifiers of receiving RI1 and RI2 is applied to a circuit H, which is a switching circuit.

The higher of the two output voltage of receivers RI1 and RI2 is selected as the output of the circuit H and is applied to the main amplifier MIFA for following circuits.

For such diversity system, it is important that each multistage receiver circuit has a linear amplification characteristic for a wide range of signal levels. If a receiver RI1 or RI2 is saturated at a highest level of input signal, and if the switching or combining of the preamplifier outputs cannot be performed properly, distortion of output signal is seriously increased.

Problems of saturation occuring in a mixer or pre- amplifier can be solved economically by using a multistage linear amplifier embodying the present invention. It is not necessary to use expensive circuitry and components in order to maintain linear amplification characteristics.

Input level versus output level characteristics of the above-described multistage linear amplifiers embodying the present invention are illustrated in the graph of Fig. 8, which will now be explained with reference to the multistage circuit of Fig. 2.

In the graph of Fig. 8, the horizontal (X) axis corresponds to input signal level P₁ of first stage amplifier 1, RFA, and the vertical (Y) axis corresponds to output signal level P₆ of second variable attenuator 5, ATT2.

When the input signal level P₁ is between a lowest level P_{1L} and a standard level P₁p, output level P₆ is linearly related to the input level as shown by the straight line a.

When input signal level P₁ exceeds the standard level P₁ₚ, the first attenuator ATT1 is initiated (i.e. begins to increase its attenuation). The output level P₃ of the first attenuator ATT1 is then held at a constant level as shown by the line c in Fig. 8, because attenuation of attenuator ATT1 increases as shown in Fig. 5(c), and output level characteristics of attenuator ATT1, as shown in the broken line b in Fig. 8, are inversely proportional to the increment of input signal level P₁ up to the highest level P_{1H}.

At the same time, second attenuator ATT2 is controlled to reduce its attenuation from its maximum attenuation as shown in Fig. 5(c) so that increase of output level from attenuator ATT2 proportional to the increase in input signal level is provided as shown by the broken line d in Fig. 8. Maximum attenuation of first attenuator ATT1 is equal to that of second attenuator ATT2. Operating characteristics of attenuator ATT2 are in inverse relationship to those of ATT1.

Therefore, output signal of second attenuator ATT2, whose input signal is compressed to a constant level P₆p corresponding to input signal P₁p to P_{1H'} is expanded linearly from P₆p to P_{6H} as shown by the straight line e in Fig. 8. Thus, a linear relationship between the level Pₛ, the output level of second attenuator ATT2, and the level P₁, input signal level of first stage amplifier, is maintained for the whole range of input signal levels from the lowest level P_{1L} to highest level P_{1H}.

As has been described above, embodiments of the present invention can provide multistage linear amplifiers for input signals having signal levels varying over a wide range.

The disclosure above has been given with respect to telecommunication receiving systems. However, it will be clear that applications of embodiments of the present invention are not limited to telecommunication systems. They can be applied in any system which requires a linear amplification of signals which vary in level over a wide range.

## Claims

1. A multistage amplifier, comprising:-
level compressor means (4) for level-compressing a signal (P₂) supplied thereto;
signal processing means (2, Fig. 2; 2', Fig. 6; 2", Fig. 7), operatively connected to the level compressor means (4), for processing the level-compressed output signal (P₃) provided by the level compressor means (4);
level expandor means (5), operatively connected to the signal processing means (2, 2', 2"), for level-expanding the amplified level-compressed output signal (P₅) provided by the signal processing means (2, 2', 2"), operable so that an amount of level-expansion effected by the level expandor means (5) corresponds to an amount of level compression effected by the level compressor means (4); and
level detecting means (6) for detecting a level of a signal in the multistage amplifier, and operable in dependence thereupon to control the level compressor means and the level expandor means so that complementary amounts of level-compression and level-expansion are provided;
characterised in that:-
first-stage amplifying means (1) are provided for amplifying an input signal (P₁) of said multistage amplifier and supplying an output signal (P₂), linearly related in level to the input signal (Pᵢ), to said level compressor means (4); in that the amount of level-compression provided by the level compressor means (4) and the amount of level-expansion provided by the level expandor means (5) are each continuously variable and proportional to the amount by which the level of the signal detected by said level detecting means exceeds a preset signal level, said preset signal level being set in correspondence to a saturation signal level of the signal processing means (2, 2', 2"); in that said signal processing means is an interstage amplifier means for linearly amplifying the level-compressed output signal (P₃) of the level compressor means (4); and in that the signal a level of which the level detecting means (6) are for detecting is a signal associated with the interstage amplifying means, for example the level-compressed output signal (P₃) or the amplified level-compressed output signal (P₅);
whereby the output signal from the multistage amplifier is linearly related to the input signal thereof and free from distortion generated in said interstage amplifier means (2, 2', 2"), and thus suitable for use in telecommunications.

2. A multistage amplifier as set forth in claim 1, wherein the level compressor means (4) and the level expandor means (5) respectively comprise attenuators (ATT1, ATT2) whose attenuation characteristics are controlled so as to be inversely related to one another.

3. A multistage amplifier as set forth in claim 2, wherein the attenuators (ATT1, ATT2) each include a diode and each has its attenuation controlled by a forward bias current supplied to its diode.

4. A multistage amplifier as set forth in any preceding claim, wherein the interstage amplifier means (2) includes a signal frequency converter circuit (MIX) for frequency conversion of the level-compressed output signal (P₃) provided by the level compressor means (4).

5. A multistage amplifier as set forth in any preceding claim, wherein the first stage amplifying means (1) has a low noise figure and an amplification gain sufficient for deterioration of the overall noise figure due to noise of following stages of the amplifier to be negligible.

6. A space diversity receiver system, comprising two multistage amplifiers, each as claimed in any preceding claim, and switching means (H) for selecting the higher level signal of the two signals provided respectively by the level-expandor means of the respective multistage amplifiers.

## Patentansprüche

1. Mehrstufiger Verstärker mit:
einer Pegelkompressoreinrichtung (4) zur Pegelkompression eines ihr gelieferten Signals (P₂);
einer Signalverarbeitungseinrichtung (2, Fig. 2; 2', Fig. 6; 2", Fig. 7), die wirkungsmäßig mit der Pegelkompressoreinrichtung (4) verbunden ist, zurVerarbeitung des pegelkomprimierten Ausgangssignals (P₃), das von der Pegelkompressoreinrichtung (4) geliefert wird;
einer Pegelexpandereinrichtung (5), die wirkungsmäßig mit der Signalverarbeitungseinrichtung (2, 2', 2") verbunden ist, zur Pegelexpandierung des verstärkten, pegelkomprimierten Ausgangssignals (P₅), welches von der Signalverarbeitungseinrichtung (2, 2', 2") geliefert wird, und so betrieben werden kann, daß ein Betrag der Pegelexpansion, die durch die Pegelexpandereinrichtung (5) bewirkt wird, einem Betrag der Pegelkompression entspricht, der durch die Pegelkompressoreinrichtung (4) bewirkt wird; und
einer Pegeldetektoreinrichtung (6) zum Detektieren eines Pegels eines Signals in dem mehrstufigen Verstärker, und welche in Abhängigkeit davon betreibbar ist, um die Pegelkompressoreinrichtung und die Pegelexpandereinrichtung so zu steuern, daß komplementäre Beträge der Pegelkompression und der Pegelexpansion geliefert werden;
dadurch gekennzeichnet,
daß eine Erststufen-Verstärkungseinrichtung (1) vorgesehen ist zur Verstärkung eines Eingangssignals (P₁) des mehrstufigen Verstärkers und zur Lieferung eines Ausgangssignals (P₂), dessen Pegel in linearer Relation zu dem Eingangssignal (P₁) ist, an die Pegelkompressoreinrichtung (4); daß der Betrag der Pegelkompression, der von der Pegelkompressoreinrichtung (4) vorgesehen wird und der Betrag der Pegelexpansion, die von der Pegelexpandereinrichtung (5) vorgesehen wird, jeweils kontinuierlich veränderlich sind und proportional zu dem Betrag, um den der Pegel des von der Pegeldetektoreinrichtung detektierten Signals einen vorbestimmten Signalpegel überschreitet, wobei der vorbestimmte Signalpegel in Entsprechung mit einem Sättigungssignalpegel der Signalverarbeitungseinrichtung (2, 2', 2") festgesetzt wird; daß die Signalverarbeitungseinrichtung eine Zwischenstufen-Verstärkereinrichtung zur linearen Verstärkung des pegelkomprimierten Ausgangssignals (P₃) der Pegelkompressoreinrichtung (4) ist; und daß das Signal, dessen Pegel von der Pegeldetektoreinrichtung (6) detektiert wird, ein Signal ist, welches mit derZwischenstufen-Verstärkereinrichtung assoziiert ist, zum Beispiel das pegelkomprimierte Ausgangssignal (P₃) oder das verstärkte, pegelkomprimierte Ausgangssignal (P₅);
wodurch das Ausgangssignal aus dem mehrstufigen Verstärker in linearer Relation zu seinem Eingangssignal steht und frei ist von Verzerrung, die in der Zwischenstufen-Verstärkereinrichtung (2, 2', 2") erzeugt wird, und so zur Verwendung in der Telekommunikation geeignet ist.

2. Mehrstufiger Verstärker, wie in Anspruch 1 ausgeführt, bei welchem die Pegelkompressoreinrichtung (4) und die Pegelexpandereinrichtung (5) jeweils Dämpfer (ATT1, ATT2) umfassen, deren Dämpfungscharakteristiken so gesteuert werden, daß sie zueinander in inverser Relation stehen.

3. Mehrstufiger Verstärker, wie in Anspruch 2 ausgeführt, bei welchem die Dämpfer (ATT1, ATT2) jeweils eine Diode enthalten und jeder eine Dämpfung hat, die durch einen Vorwärtsspannungsstrom gesteuert wird, der seiner Diode zugeführt wird.

4. Mehrstufiger Verstärker, wie in irgendeinem vorhergehenden Anspruch ausgeführt, bei welchem die Zwischenstufen-Verstärkereinrichtung (2) eine Signalfrequenzwandlerschaltung (MIX) zur Frequenzwandlung des pegelkomprimierten Ausgangssignals (P₃) enthält, welches von der Pegelkompressoreinrichtung (4) geliefert wird.

5. Mehrstufiger Verstärker, wie in irgendeinem vorhergehenden Anspruch ausgeführt, bei welchem die Erststufen-Verstärkungseinrichtung (1) eine niedrige Rauschzahl und einen Verstärkungsfaktor hat, der ausreicht für die Verringerung der gesamten Rauschzahl auf Grund des Rauschens der folgenden Stufen des Verstärkers, um vernachlässigbar zu sein.

6. Raum-Diversity-Empfänger-System, mit zwei mehrstufigen Verstärkern, jeweils wie in irgendeinem vorhergehenden Anspruch beansprucht, und mit einer Schalteinrichtung (H) zur Auswahl des Signals mit höherem Pegel von den beiden Signalen, die jeweils von der Pegelexpandereinrichtung der entsprechenden mehrstufigen Verstärker geliefert werden.

## Revendications

1. Amplificateur à étages multiples, comportant :
un dispositif (4) compresseur de niveau destiné à compresser le niveau d'un signal (P₂) qui lui est transmis,
un dispositif (2, figure 2 ; 2', figure 6 ; 2", figure 7) de traitement de signaux, connecté au dispositif (4) compresseur de signaux et destiné à traiter le signal (P₃) de sortie ayant subi la compression de niveau transmis par le dispositif (4) compresseur de niveau,
un dispositif (5) expanseur de niveau connecté au dispositif (2, 2', 2") de traitement de signaux et destiné à assurer l'expansion de niveau du signal amplifié de sortie (P5) ayant subi la compression de niveau transmis par le dispositif (2, 2', 2") de traitement de signaux, et réalisé de manière que l'amplitude d'expansion de niveau réalisée par le dispositif (5) expanseurde niveau corresponde à l'amplitude de compression de niveau réalisée par le dispositif (4) compresseur de niveau, et
un dispositif (6) de détection de niveau destiné à détecter un niveau d'un signal dans l'amplificateur à étages multiples, et, en fonction de ce niveau, à régler le dispositif compresseur de niveau et le dispositif expanseur de niveau de manière que les amplitudes de compression de niveau et d'expansion de niveau soient complémentaires,
caractérisé en ce que
un dispositif amplificateur (1) d'un premier étage est destiné à amplifier un signal d'entrée (Pᵢ) de l'amplificateur à étages multiples, et à transmettre un signal de sortie (P₂) relié linéairement en niveau au signal d'entrée (Pᵢ), transmis au dispositif (4) compresseur de niveau, en ce que l'amplitude de compression de niveau réalisée par le dispositif (4) compresseur de niveau et l'amplitude d'expansion de niveau assurée par le dispositif (5) expanseur de niveau sont chacune variables de façon continue et proportionnelles à l'amplitude de dépassement d'un niveau de signal préréglé par le niveau du signal détecté par le dispositif de détection de niveau, le niveau du signal préréglé étant déterminé afin qu'il corresponde à un niveau de signal de saturation du dispositif (2, 2', 2") de traitement de signaux, en ce que le dispositif de traitement de signaux est un dispositif amplificateur placé entre des étages et destiné à amplifier linéairement le signal (P₃) de sortie ayant subi la compression de niveau du dispositif (4) compresseur de niveau, et en ce que le signal dont le niveau doit être détecté par le dispositif (6) de détection de niveau est un signal associé au dispositif amplificateur placé entre les étages, par exemple le signal (P₃) de sortie ayant subi la compression de niveau ou le signal (P5) de sortie amplifié et ayant subi la compression de niveau
si bien que le signal de sortie de l'amplificateur à étages multiples est relié linéairement à son signal d'entrée et est dépourvu de la distorsion créée dans le dispositif amplificateur (2, 2', 2") placé entre les étages et peut ainsi être utilisé dans des télécommunications.

2. Amplificateur à étages multiples selon la revendication 1, dans lequel le dispositif (4) compres- seurde niveau et le dispositif (5) expanseur de niveau comprennent respectivement des atténuateurs (ATT1, ATT2) dont les caractéristiques d'atténuation sont réglées afin qu'elles soient liées en proportions inverses l'une de l'autre.

3. Amplificateur à étages multiples selon la revendication 2, dans lequel les atténuateurs (ATT1, ATT2) comportent chacun une diode et ont chacun leur atténuation réglée par un courant de polarisation dans le sens direct transmis à sa diode.

4. Amplificateur à étages multiples selon l'une quelconque des revendications précédentes, dans lequel le dispositif (2) amplificateur placé entre les étages comporte un circuit (MIX) convertisseur de fréquences de signaux destiné à transformer la fréquence du signal (P₃) de sortie ayant subi la compression de niveau transmis par le dispositif (4) compresseur de niveau.

5. Amplificateur à étages multiples selon l'une quelconque des revendications précédentes, dans lequel le dispositif (1) d'amplification du premier étage a un faible chiffre de bruit et un gain d'amplification suffisant pour que la dégradation du chiffre global de bruit résultant du bruit dans les étages suivants de l'amplificateur soit négligeable.

6. Système récepteur à diversité spatiale comportant deux amplificateurs à étages multiples chacun selon l'une quelconque des revendications précédentes, et un dispositif (H) de commutation destiné à sélectionner le signal de plus haut niveau parmi les deux signaux transmis respectivement par les dispositifs expanseurs de niveau des amplificateurs respectifs à étages multiples.
